# EUROPEAN PATENT APPLICATION

(11) **EP 4 369 875 A1**
(43) Date of publication of application: **15.05.2024**
(21) Application number: 22860327.0
(22) Date of filing: 16.08.2022
(51) Int. Cl.: H05K 1/11, H01R 12/62, H01B 7/04

(54) **ELECTRONIC DEVICE**

(30) Priority: 24.08.2021 CN 202110974592
(71) Applicant: Huawei Technologies Co., Ltd., Shenzhen, Guangdong 518129 (CN)
(72) Inventor: MA, Yixin, Shenzhen, Guangdong 518129 (CN); CHEN, Jinbang, Shenzhen, Guangdong 518129 (CN); TANG, Huijun, Shenzhen, Guangdong 518129 (CN); ZENG, Rui, Shenzhen, Guangdong 518129 (CN)
(74) Representative: Körber, Martin Hans
(86) International application number: PCT/CN2022/112870
(87) International publication number: WO 2023/024981

(57) **Abstract**

This application provides an electronic device. The electronic device includes a housing and a display screen. The display screen is disposed on the housing. The electronic device further includes a carrier board and a flexible flat cable. The carrier board is loaded with a device. The carrier board and the flexible flat cable are disposed between the housing and the display screen, and the flexible flat cable is soldered to the carrier board. In this application, an existing connector may be canceled in a connection manner in which the flexible flat cable is soldered to the carrier board, so that a distance between the housing and the display screen may be reduced from a sum of a thickness of the carrier board and a height of the connector to a sum of the thickness of the carrier board and a height of the device on the carrier board. This facilitates implementation of a thin design of the electronic device. In addition, canceling the connector may save large under-screen space, so that a layout and optimization of devices and lines are facilitated.

## Description

This application claims priority to Chinese Patent Application No. 202110974592.7, filed with the China National Intellectual Property Administration on August 24, 2021, and entitled "ELECTRONIC DEVICE", which is incorporated herein by reference in its entirety.

### TECHNICAL FIELD

This application relates to the field of electronic terminal technologies, and in particular, to an electronic device.

### BACKGROUND

Both an FFC (Flexible flat cable, flexible flat cable) flat cable and an FPC (Flexible printed circuit, flexible printed circuit) may be flexible flat cables used for a signal connection in an electronic product such as a display, a notebook computer, a desktop computer, or a mobile phone. Currently, the FFC flat cable or the FPC flat cable can be connected to a PCB (Printed circuit board, printed circuit board) only by installing a connector on the PCB board, and the connection to the FFC flat cable or the FPC flat cable through the connector implements signal transmission. However, a height of the connector in a direction perpendicular to a screen surface is large, and there is a high width requirement. As a result, a screen-to-body ratio of the screen is small, and under-screen space is small.

### SUMMARY

An objective of this application is to provide an electronic device, to resolve a problem in a conventional technology that an electronic product cannot be light and thin through a connector to be connected to an FFC flat cable.

This application provides an electronic device. The electronic device includes a housing and a display screen. The display screen is disposed on the housing. The electronic device further includes a carrier board and a flexible flat cable. The carrier board is loaded with a device. The carrier board and the flexible flat cable are disposed between the housing and the display screen, and the flexible flat cable is soldered to the carrier board.

In this application, an existing connector may be canceled in a connection manner in which the flexible flat cable is soldered to the carrier board, so that a distance between the housing and the display screen may be reduced from a sum of a thickness of the carrier board and a height of the connector to a sum of the thickness of the carrier board and a height of the device on the carrier board. This facilitates implementation of a thin design of the electronic device. In addition, canceling the connector may save large under-screen space, so that a layout and optimization of devices and lines are facilitated.

In a possible implementation, a height of soldering between the flexible flat cable and the carrier board is less than the height of the device on the carrier board, or a thickness of soldering between the flexible flat cable and the carrier board is less than a thickness of the device on the carrier board. Therefore, the distance between the housing and the display screen of the electronic device may be further reduced to at least a sum of the thickness of the carrier board 1 and the thickness of the device. This facilitates implementation of the thin design of the electronic device.

In a possible implementation, the flexible flat cable includes a conductive layer, and the conductive layer is at least partially provided with a soldering layer; and/or a hole for filling solder is disposed on the conductive layer.

In a case in which the conductive layer is at least partially provided with the soldering layer, and there is no hole on the conductive layer, the soldering layer may be disposed to have better combination effect between the soldering layer and the solder, enhance solderability, and improve soldering strength between the flexible flat cable and the carrier board.

In a case in which the hole for filling the solder is disposed on the conductive layer, and there is no soldering layer, the solder is filled on the carrier board through the hole, so that both sides of the conductive layer can have the solder, and a soldering operation is simplified while soldering strength is ensured.

In a case in which both the soldering layer and the hole for filling the solder are disposed on the conductive layer, a soldering operation may be simplified, and reliability of a soldering connection between the conductive layer and the carrier board may also be implemented.

In a possible implementation, the flexible flat cable further includes an insulation layer, a soldering region is disposed on a conductive layer, and the insulation layer covers a part that is on the conductive layer and that is located outside the soldering region. In this way, contact between the conductive layer and another component may be effectively isolated, and electric leakage may be avoided. In addition, no insulation layer is disposed in the soldering region, so that the conductive layer may be soldered to the carrier board through the soldering region of the conductive layer, to implement the connection between the flexible flat cable and the carrier board. In addition, the insulation layer may also enhance strength and bending resistance of the flexible flat cable, to avoid deformation or damage caused by slight interference on the flexible flat cable.

In a possible implementation, a window is disposed on the insulation layer, and the window is aligned with a position of the soldering region. The window is disposed on the insulation layer, so that not only soldering is convenient, but also a soldering position may be specified more flexibly. In addition, lines located on two sides of the soldering region may be bent for application as required, so that an application form of the flexible flat cable is more extensive.

In a possible implementation, the soldering region is disposed at an end of the conductive layer, and the end that is on the conductive layer and that has the soldering region extends out from the insulation layer. One end that is on the conductive layer and that extends out from the insulation layer may be directly soldered to the carrier board, so that no window needs to be disposed on the insulation layer.

In a possible implementation, in a soldered state, an adhesive layer is disposed between the soldering region and the insulation layer. Therefore, strength and bending resistance of the conductive layer at a boundary interface position may be enhanced.

In a possible implementation, a material of the insulation layer is one or a combination of two or more of polytrimethylene terephthalate (PET), polyimide (PI), liquid crystal polymer (LCP), and polyether ether ketone (PEEK). Therefore, the insulation layer may obtain features of excellent electrical insulation, fatigue resistance, and the like.

In a possible implementation, the insulation layer includes a polytrimethylene terephthalate (PET) layer and a polyimide (PI) layer, the polyimide (PI) layer covers a position, of the conductive layer, near the soldering region, and the polytrimethylene terephthalate (PET) layer covers a position, of the conductive layer, far away from the soldering region. A form of combining the PET layer and the PI layer for application is used on the entire insulation layer. To be specific, the insulation layer may use a PI material near the soldering region, and use a high-temperature-resistant feature of the PI material to avoid a problem of heat melting and ensure soldering quality; and use a PET material at a position far away from the soldering region, to implement insulation and protection effect, so that costs of the insulation layer may be effectively reduced.

In a possible implementation, the insulation layer includes a first film layer and a second film layer, and the first film layer and the second film layer are respectively disposed on two sides of the conductive layer. In this way, process processing is facilitated.

In a possible implementation, a material of the soldering layer is tin, gold, or silver. Tin, gold, or silver has strong solderability, and can effectively ensure strength and reliability of soldering between the conductive layer and the carrier board.

In a possible implementation, the conductive layer includes at least one copper sheet. The copper sheet has a specific width. This facilitates a hole to be disposed on a surface and facilitates soldering and fixing between the copper sheet and the carrier board.

In a possible implementation, the flexible flat cable is soldered to the carrier board by using a laser soldering process, an ultrasonic soldering process, a reflow soldering process, or a hot bar reflow soldering process. In this way, stability of soldering quality may be ensured.

In a possible implementation, the carrier board is one of a camera module sub-board, a microphone sub-board, or a multilayer PCB board.

It should be understood that the foregoing general descriptions and the following detailed descriptions are merely examples, and are not intended to limit this application.

### BRIEF DESCRIPTION OF DRAWINGS

FIG. 1 is a state diagram of a connection between a circuit board and a line in the conventional technology;
FIG. 2 is a state diagram (1) of a conductive layer having a soldering layer but without a hole in soldering;
FIG. 3 is a state diagram (2) of a conductive layer having a soldering layer but without a hole in soldering;
FIG. 4 is a state diagram of a conductive layer having a hole but without a soldering layer in soldering;
FIG. 5 is a schematic diagram of disposing a hole in a soldering region of a conductive layer;
FIG. 6 is a state diagram of a conductive layer having both a hole and a soldering layer in soldering;
FIG. 7 is a three-dimensional diagram in which an insulation layer is disposed on a conductive layer (where the insulation layer has a window);
FIG. 8 is a sectional view in which an insulation layer is disposed on a conductive layer (where the insulation layer has a window);
FIG. 9 is a three-dimensional diagram in which an insulation layer is disposed on a conductive layer (where the insulation layer does not have a window);
FIG. 10 is a sectional view in which an insulation layer is disposed on a conductive layer (where the insulation layer does not have a window);
FIG. 11 is a schematic structural diagram in which an insulation layer made of a PI material is disposed on a conductive layer (where an end of the conductive layer does not extend out from the insulation layer);
FIG. 12 is a schematic structural diagram in which an insulation layer including a PET layer and a PI layer is disposed on a conductive layer;
FIG. 13 is a schematic structural diagram of a notebook computer;
FIG. 14 is a sectional view in which an insulation layer is disposed on a conductive layer having a soldering layer (where the insulation layer includes a PET layer and a PI layer);
FIG. 15 is a schematic structural diagram in which an insulation layer made of a PI material is disposed on a conductive layer (where an end of the conductive layer extends out from the insulation layer); and
FIG. 16 is a state diagram of glue dispensing in a soldering region.

### Reference numerals:

100: circuit board;
200: connector;
300: device;
400: line;
1: carrier board;
2: flexible flat cable;
21: conductive layer;
211: hole;
22: insulation layer;
221: first film layer;
222: second film layer;
23: soldering layer;
24: window;
25: PET layer;
26: PI layer;
3: solder;
4: notebook computer;
41: housing
42: mainboard;
43: display screen; and
5: glue.

The accompanying drawings herein are incorporated into this specification and constitute a part of this specification, show embodiments conforming to this application, and are used, together with this specification, to explain a principle of this application.

### DESCRIPTION OF EMBODIMENTS

To make the objectives, technical solutions, and advantages of this application clearer and more comprehensible, the following further describes this application in detail with reference to the accompanying drawings and embodiments. It should be understood that the specific embodiments described herein are merely used to explain this application but are not intended to limit this application.

In the descriptions of this application, unless otherwise explicitly specified and limited, the terms "first" and "second" are merely used for description purposes, and cannot be understood as indicating or implying relative importance. Unless otherwise specified or indicated, the term "a plurality of" means two or more. The terms "connection", "fixed", and the like should be understood in a broad sense. For example, "connection" may be a fixed connection, or may be a detachable connection, an integrated connection, or an electrical connection, or may be a direct connection or an indirect connection through an intermediate medium. A person of ordinary skill in the art may understand specific meanings of the foregoing terms in this application according to specific cases.

In the descriptions of this specification, it should be understood that the orientation words such as "above" and "below" described in embodiments of this application are described from the perspective shown in the accompanying drawings, and should not be construed as a limitation on embodiments of this application. Moreover, in the context, it also should be understood that, when it is mentioned that one element is connected "above" or "below" another element, the element can be directly connected "above" or "below" the another element, or may be indirectly connected "above" or "below" the another element through an intermediate element.

Embodiments of this application provide an electronic device. The electronic device includes a device having a display screen and a housing, for example, a display, a notebook computer, a desktop computer, an all-in-one machine, a mobile phone, a tablet computer, or a smartwatch. A specific type of the electronic device is not specifically limited in embodiments. The electronic device usually includes the display screen and the housing. A circuit board is integrated between the display screen and the housing, and various devices that can implement different functions, for example, a camera module and a microphone module, are configured on the circuit board. These types of devices need to be connected to a main control unit of the electronic device through a line, and the main control unit may perform signal transmission through the line to implement the foregoing functions.

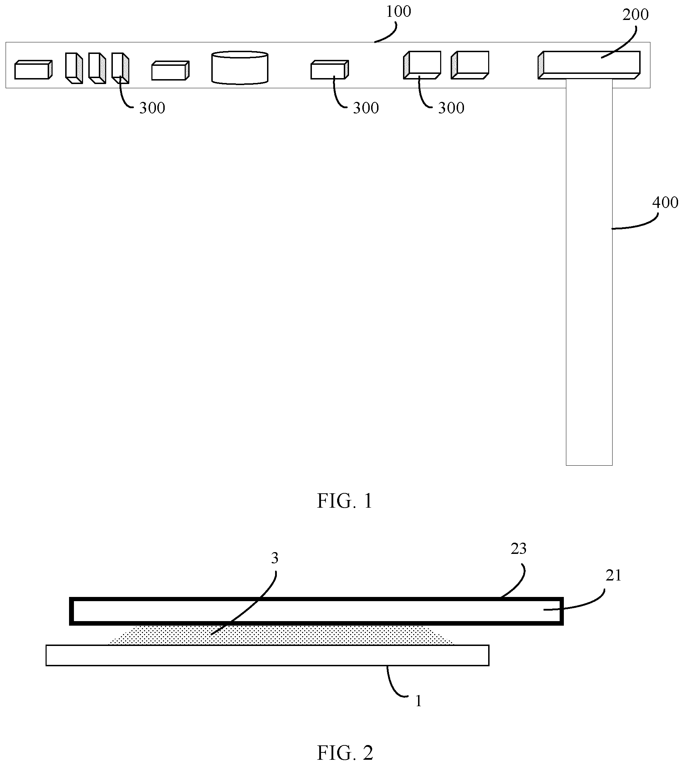

FIG. 1 is a state diagram of a connection between a circuit board and a line in the conventional technology. As shown in FIG. 1, an existing line usually needs to be connected to a circuit board 100 through a connector 200 (for example, a BTB/Zif/WTB connector). To be specific, the connector needs to be soldered on the circuit board 100, and then a line 400 is inserted into an interface of the connector 200, to complete a connection between the line 400 and the circuit board 100. However, all existing connectors 200 are of a three-dimensional block structure, and a height of the connector 200 in a Z direction (a direction perpendicular to a surface of a display screen) is large, and is usually greater than a height of a device 300 on the circuit board 100. This requires a large distance between a housing and the display screen, and consequently it is difficult to implement a thin design of an electronic device. In addition, an overall volume of the connector 200 is large, which causes a decrease in under-screen space of the electronic device. In addition, there is a high width requirement of the connector 200 in a direction parallel to the display screen, which also causes a decrease in a screen-to-body ratio of the screen.

Therefore, embodiments of this application provide an electronic device. The electronic device includes a housing and a display screen. The display screen is disposed on the housing. The electronic device further includes a carrier board 1 and a flexible flat cable 2. The carrier board 1 is loaded with a device that can implement various functions. The carrier board 1 and the flexible flat cable 2 are disposed between the housing and the display screen, and the flexible flat cable 2 is soldered to the carrier board 1. The carrier board 1 may be a circuit board, for example, a single-layer or multi-layer PCB (Printed circuit board, printed circuit board) board or an FPC (Flexible printed circuit, flexible printed circuit) board. The carrier board 1 has a specific width and length, and a surface of the carrier board 1 may be mounted with a device that implements various functions. A thickness of the carrier board 1 is small. When the carrier board 1 is disposed on the housing, the surface of the carrier board 1 is parallel to a surface of the display screen. In this case, the thickness of the carrier board 1 and a height of the device on the carrier board 1 limit a distance between the housing and the display screen. However, an existing connector may be canceled in a connection manner in which the flexible flat cable 2 is soldered to the carrier board 1, and a height of soldering between the flexible flat cable 2 and the carrier board 1 at a soldering position is far less than the height of the device on the carrier board 1, so that the distance between the housing and the display screen may be reduced from a sum of the thickness of the carrier board 1 and a height of the connector to a sum of the thickness of the carrier board 1 and the height of the device on the carrier board 1. This facilitates implementation of a thin design of the electronic device. In addition, canceling the connector may save large under-screen space, and the under-screen space is space between the display screen and the housing, so that a layout and optimization of devices and lines are facilitated.

In addition, because the connector has a large size in a width direction and a length direction, the circuit board to which the connector is connected also needs to have a large size, and consequently a screen-to-body ratio is reduced. In embodiments, application of the connector is replaced by soldering, and a soldering region does not need to occupy a large area on the carrier board 1, so that width and length sizes of the carrier board 1 may be reduced, and the screen-to-body ratio is increased.

The flexible flat cable 2 may be a flexible flat cable such as an FFC (Flexible flat cable, flexible flat cable) flat cable or an FPC (Flexible printed circuit, flexible printed circuit) flat cable. In embodiments, the flexible flat cable 2 is preferably an FFC flat cable, and the FFC flat cable may randomly select a quantity of wires and a spacing between the wires, so that wiring is more convenient, and a volume of the electronic device is greatly reduced.

It should be noted that the height of soldering between the flexible flat cable 2 and the carrier board 1 is less than the height of the device on the carrier board 1, or a thickness of soldering between the flexible flat cable 2 and the carrier board 1 is less than a thickness of the device on the carrier board 1. The height of soldering between the flexible flat cable 2 and the carrier board 1 and the height of the device on the carrier board 1 are height sizes perpendicular to the surface of the display screen, or the thickness of soldering between the flexible flat cable 2 and the carrier board 1 and the thickness of the device on the carrier board 1 are thickness sizes perpendicular to the surface of the display screen. This application is described by using an example in which the thickness of soldering between the flexible flat cable 2 and the carrier board 1 is less than the thickness of the device on the carrier board 1.

It may be understood that, for an existing electronic device in which a connector is applied, because a thickness of the connector is usually greater than a thickness of a device on a carrier board, a thickness of the electronic device is determined by both a thickness of the carrier board and the thickness of the connector on the carrier board, that is, the overall thickness of the electronic device is at least greater than a sum of the thickness of the carrier board and the thickness of the connector. Consequently, the thickness of the electronic device cannot be further reduced, and it is difficult to implement a thin design of the electronic device. Therefore, in embodiments, the existing connector may be canceled in the connection manner in which the carrier board 1 is soldered to the flexible flat cable 2, and the thickness of soldering between the flexible flat cable 2 and the carrier board 1 at the soldering position is far less than the height of the device on the carrier board 1, so that the distance between the housing and the display screen of the electronic device may be further reduced to at least the sum of the thickness of the carrier board 1 and the thickness of the device. This facilitates implementation of the thin design of the electronic device.

The flexible flat cable 2 includes a conductive layer 21. The conductive layer 21 may implement signal transmission between a main control unit and the carrier board 1. In addition, the flexible flat cable 2 may be directly soldered to the carrier board 1 through the conductive layer 21.

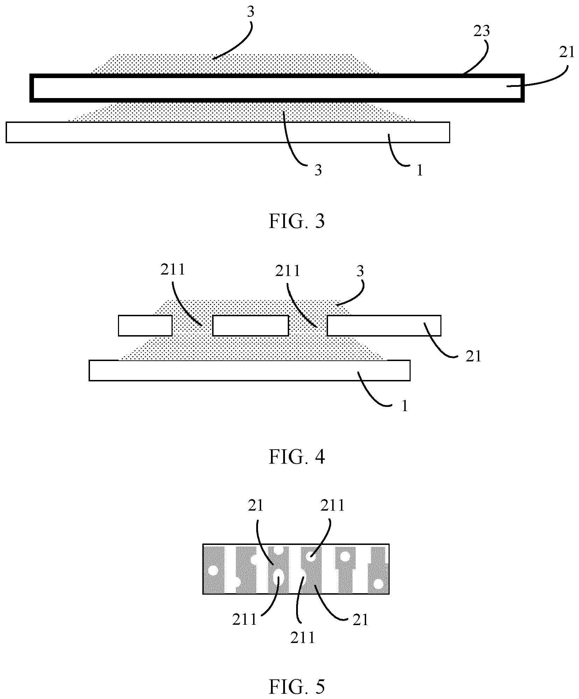

In a specific embodiment, the conductive layer 21 is at least partially provided with a soldering layer 23, and there is no hole 211 on the conductive layer 21. Specifically, the soldering layer 23 may be disposed on the conductive layer 21 and is in a specific region in which the conductive layer 21 is soldered to the carrier board 1. In a soldering operation manner, as shown in FIG. 2, a solder 3 may be first added to a soldering part on the carrier board 1, then a soldering part on the conductive layer 21 is lapped to the soldering part on the carrier board 1, and a lap position between the conductive layer 21 and the carrier board 1 is soldered by using a preset soldering process. In another soldering operation manner, as shown in FIG. 3, a solder 3 may alternatively be first added to a soldering part on the carrier board 1, then a soldering part on the conductive layer 21 is lapped to the soldering part on the carrier board 1, and then the solder 3 is added to the soldering part on the conductive layer 21, so that the soldering part on the conductive layer 21 is buried in the solder 3; and then a lap position between the conductive layer 21 and the carrier board 1 is soldered by using a preset soldering process.

During soldering, a temperature at the soldering position is high, and the soldering layer 23 and the solder 3 are melted and combined into one, so that a reliable connection between the conductive layer 21 and the carrier board 1 is implemented by melting the soldering layer 23 and the solder 3.

In comparison with the manner in which the conductive layer 21 is directly soldered to the carrier board 1, the soldering layer 23 is disposed on the conductive layer 21, so that the soldering layer 23 and the solder 3 have better combination effect, solderability is enhanced, and soldering strength between the flexible flat cable 2 and the carrier board 1 is improved.

It should be noted that, the conductive layer 21 is generally of a long length. Before the soldering layer 23 is disposed on the conductive layer 21, a position at which the soldering layer 23 needs to be disposed on the conductive layer 21 may be determined based on a length requirement, of the flexible flat cable 2, required by the electronic device. Certainly, to simplify a process of disposing the soldering layer 23 on the conductive layer 21, the surface of the conductive layer 21 may also be completely provided with the soldering layer 23. When the soldering layer 23 is applied to the electronic device, only a length that meets a requirement of the electronic device needs to be intercepted.

In another specific embodiment, as shown in FIG. 4 and FIG. 5, a hole 211 for filling the solder 3 may be disposed on the conductive layer 21, and the conductive layer 21 does not have the soldering layer 23. In the soldering operation process, the soldering part on the conductive layer 21 may be lapped to the soldering part on the carrier board 1, and then the solder 3 is added to the conductive layer 21. Because the hole 211 is disposed on the conductive layer 21, the solder 3 may be filled on the carrier board 1 through the hole 211, and then a lap position between the conductive layer 21 and the carrier board 1 may be soldered by using a preset soldering process. In this embodiment, the solder 3 may be filled between the conductive layer 21 and the carrier board 1 from a side, of the conductive layer 21, far away from the carrier board 1 through the hole 211 on the conductive layer 21, so that both sides of the conductive layer 21 can have the solder 3. In the soldering process, the melted solder 3 may completely wrap the soldering part on the conductive layer 21 and fix the soldering part to the carrier board 1, to improve soldering strength between the conductive layer 21 and the carrier board 1. In addition, in this embodiment, only the solder 3 needs to be added to the conductive layer 21. This simplifies the soldering operation.

The hole 211 on the conductive layer 21 may be provided on the soldering part on the conductive layer 21, so that the solder 3 passes through the hole 211. The hole 211 may be implemented by using a process of laser drilling 211 or mechanical drilling 211. This is not limited in this embodiment.

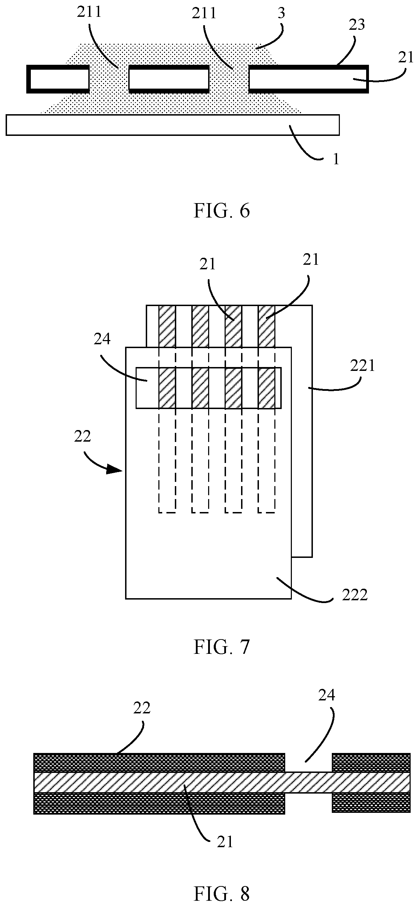

In still another specific embodiment, as shown in FIG. 6, both the soldering layer 23 and the hole 211 for filling the solder 3 are disposed on the conductive layer 21. In the soldering operation process, the soldering part on the conductive layer 21 may be lapped to the soldering part on the carrier board 1, and then the solder 3 is added to the conductive layer 21. Because the hole 211 is disposed on the conductive layer 21, the solder 3 may be filled on the carrier board 1 through the hole 211, and then a lap position between the conductive layer 21 and the carrier board 1 may be soldered by using a preset soldering process. During soldering, the soldering layer 23 and the solder 3 are melted and combined with high heat. In addition, the melted soldering layer 23 and the solder 3 can completely wrap the soldering part on the conductive layer 21 and fix the soldering part to the carrier board 1. Therefore, this embodiment not only simplifies the soldering operation, but also implements reliability of the soldering connection between the conductive layer 21 and the carrier board 1.

A soldering process used between the flexible flat cable 2 and the carrier board 1 may be a laser soldering process, an ultrasonic soldering process, a reflow soldering process, a hot bar reflow soldering process, or the like.

In addition, the solder 3 may be a tin material. The solder 3 may be added in a manner of prefabricating tin at a soldering position on the carrier board 1, or may be manually tinned, for example, by using a tin wire feeding or tin spraying process. This is not limited in this embodiment.

In a specific implementation, the flexible flat cable 2 further includes an insulation layer 22, a soldering region is disposed on the conductive layer 21, and the insulation layer 22 covers a part that is on the conductive layer 21 and that is located outside the soldering region. The soldering region is a region in which the conductive layer 21 needs to be soldered to the carrier board 1 by using a soldering process. It may be understood that, the carrier board 1 in the electronic device usually maintains a specific distance from a main control unit, and needs to be connected through the flexible flat cable 2. The flexible flat cable 2 is easy to contact a component located between the carrier board 1 and the main control unit. If the entire conductive layer 21 is in an exposed state, electric leakage is easily caused, causing problems such as a short circuit and ablation between the flexible flat cable 2 and another component. Therefore, in this embodiment, the insulation layer 22 is disposed at a part that is on the conductive layer 21 and that is located outside the soldering region, so that the conductive layer 21 may be effectively isolated from contact with the another component, to avoid electric leakage. In addition, the insulation layer 22 is not disposed in the soldering region, so that the conductive layer 21 may be soldered to the carrier board 1 through the soldering region of the conductive layer 21, to implement the connection between the flexible flat cable 2 and the carrier board 1. In addition, the insulation layer 22 may also enhance strength and bending resistance of the flexible flat cable 2, to avoid deformation or damage caused by slight interference on the flexible flat cable 2.

In a specific embodiment, as shown in FIG. 7 and FIG. 8, the insulation layer 22 may completely wrap the conductive layer 21, and a window 24 is disposed only at a position opposite to the soldering region, so that the soldering region can be exposed through the window 24, and the solder 3 is added to the soldering region and the soldering operation is performed through the window 24. The soldering region may be disposed at a specified position between two ends of the conductive layer 21, and the window 24 may be disposed at a corresponding position on the insulation layer 22 based on the specified soldering position. Therefore, the window 24 is disposed on the insulation layer 22, so that not only soldering is convenient, but also the soldering position may be specified more flexible. In addition, lines located on two sides of the soldering region may be bent as required, so that an application form of the flexible flat cable 2 is more extensive.

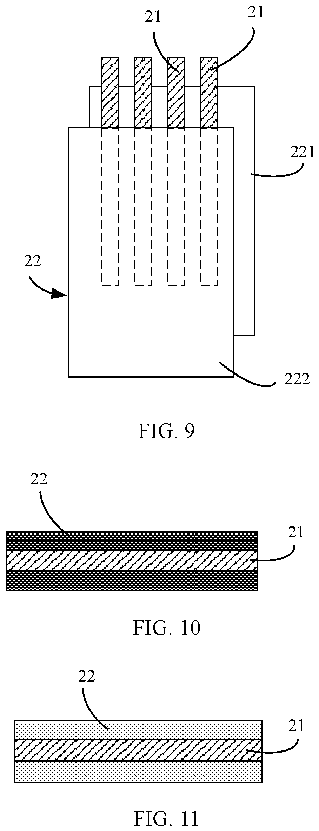

In another specific embodiment, as shown in FIG. 9 and FIG. 10, the soldering region may be disposed at an end of the conductive layer 21, to be specific, a segment of length located at the end of the conductive layer 21 may be the soldering region, and the end, of the conductive layer 21, having the soldering region extends out from the insulation layer 22. In this embodiment, one end that is on the conductive layer 21 and that extends out from the insulation layer 22 may be directly soldered to the carrier board 1, so that no window 24 needs to be disposed on the insulation layer 22. A length of the insulation layer 22 may be determined based on a length requirement of the conductive layer 21.

In addition, it should be noted that, in this embodiment, the end, of the conductive layer 21, having the soldering region on extends out from the insulation layer 22, that is, only one side of the soldering region has the insulation layer 22. A cross section of the insulation layer 22 forms a boundary interface between the soldering region and the insulation layer 22. Apart, of the flexible flat cable 2, having the insulation layer 22 has strong bending resistance. However, a soldering region having no insulation layer 22 has weak bending resistance and is vulnerable to bending and deformation, and a part that is vulnerable to bending and deformation occurs at the boundary interface position. Consequently, bending and deformation cause fatigue fracture of the conductive layer 21 located at the boundary interface position. Therefore, after the soldering, an adhesive layer may be disposed between the soldering region and the insulation layer 22, that is, the adhesive layer is preferably disposed at the boundary interface position, to enhance strength and bending resistance of the conductive layer 21 at the boundary interface position.

Specifically, a material of the insulation layer 22 is, but is not limited to, one or a combination of two or more of polyethylene terephthalate (PET), polyimide (PI), liquid crystal polymer (LCP), and polyether ether ketone (PEEK). The insulation layer 22 may be completely made of any one of the foregoing materials. The insulation layer 22 may also have a plurality of segments, each segment may be made of any one of the foregoing materials, and then the segments are combined to form the complete insulation layer 22. Lengths of the segments may be the same or may be different, and may be specifically determined based on a size specification of the conductive layer 21 and the position of the soldering region. The insulation layer 22 may be disposed on the conductive layer 21 by using a hot-pressed process, or certainly may be disposed by using another existing process. This is not limited in this embodiment.

In a specific embodiment, the material of the insulation layer 22 is PET. The insulation layer 22 of the PET material has excellent electrical insulation, creep resistance, fatigue resistance, friction resistance, and dimensional stability, and costs of the PET material are low. This saves manufacturing costs of the electronic device.

In another specific embodiment, because a hot melting point of the PET material is 105°C, in the soldering process of the soldering region of the conductive layer 21, there is a heat-affected region in a specific range around the soldering region. The heat-affected region is formed by heat diffusion of the soldering region, and a temperature of the heat-affected region is still high. As a result, problems that the PET material in contact with the heat-affected region is melted and flows to the soldering position, forming a hole at the soldering position, and the like are caused. Therefore, in this embodiment, as shown in FIG. 11, the material of the insulation layer 22 is PI. Because temperature resistance of the insulation layer 22 is up to 400°C, the insulation layer 22 does not melt when the insulation layer 22 is in contact with the heat-affected region, to ensure soldering effect between the conductive layer 21 and the carrier board 1, and prevent a hole from being formed at the soldering position.

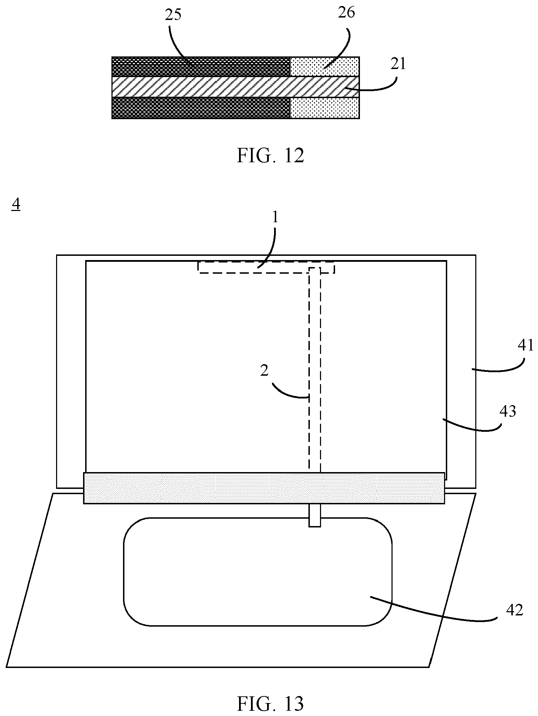

In still another specific embodiment, as shown in FIG. 12, the insulation layer 22 includes a PET layer 25 and a PI layer 26, and the PI layer 26 covers a position, of the conductive layer 21, near the soldering region. It should be noted that costs of the PI material are far higher than costs of the PET material. If the insulation layer 22 is made of the PI material, overall costs of the electronic device are increased. Therefore, in this embodiment, a form of combining the PET layer 25 and the PI layer 26 for application is used on the entire insulation layer 22. To be specific, the insulation layer 22 may use a PI material near the soldering region, and use a high-temperature-resistant feature of the PI material to avoid a problem of heat melting and ensure soldering quality; and use a PET material at a position far away from the soldering region, to implement insulation and protection effect, so that costs of the insulation layer 22 may be effectively reduced.

Specifically, as shown in FIG. 7 and FIG. 9, the insulation layer 22 includes a first film layer 221 and a second film layer 222, and the first film layer 221 and the second film layer 222 are respectively disposed on two sides of the conductive layer 21. Both the first film layer 221 and the second film layer 222 may be film sheets. When the flexible flat cable 2 is prepared, the conductive layer 21 may be disposed between the first film layer 221 and the second film layer 222, and the first film layer 221, the conductive layer 21, and the second film layer 222 are hot-pressed into an integrated structure by using a hot-pressed process, so that the first film layer 221 and the second film layer 222 fixedly wrap the conductive layer 21.

In a specific implementation, a material of the soldering layer 23 is tin, gold, or silver. The soldering layer 23 is a layer of plating formed by using a surface processing process on the conductive layer 21. Tin, gold, or silver has strong solderability, and can effectively ensure strength and reliability of soldering between the conductive layer 21 and the carrier board 1. In this embodiment, the material of the soldering layer 23 is preferably tin, and the tin material used as the soldering layer 23 can not only ensure soldering strength, but also reduce costs.

In a specific implementation, a material of the conductive layer 21 may be copper, and may specifically include at least one copper sheet. The copper sheet has a specific width, and a through hole 211 may be provided on a surface of the copper sheet, so that the solder 3 is added to the hole 211 and is added between the copper sheet and the carrier board 1 after the solder 3 passes through the hole 211. This ensures soldering reliability.

In a specific implementation, the carrier board 1 in embodiments of this application may be one of a camera module sub-board, a microphone sub-board, or a multilayer PCB board.

This application is specifically described by using the following embodiments.

### Embodiment 1

As shown in FIG. 13, the electronic device may be a product of a notebook computer 4, the carrier board 1 may be a camera module sub-board, and the camera module sub-board is fixed on a housing 41 of the notebook computer, and is located between a display screen 43 and the housing 41. The flexible flat cable 2 is an FPC flat cable. One end of the FPC flat cable may be soldered to the camera module sub-board by using a laser soldering process, an ultrasonic soldering process, a reflow soldering process, a hot bar reflow soldering process, or the like. The other end of the FPC flat cable is connected to a mainboard 42 of the notebook computer 4, so that signal transmission between the mainboard 42 and the camera module sub-board may be implemented through the FPC flat cable. In this embodiment, as shown in FIG. 4 and FIG. 5, the hole 211 for adding the solder 3 may be disposed on the conductive layer 21 of the FPC flat cable in a manner of mechanical drilling 211, laser drilling 211, or the like, the insulation layer 22 is disposed outside the conductive layer 21, and a material of the insulation layer 22 is PI, as shown in FIG. 11. The conductive layer 21 is a copper wire.

In this embodiment, the solder 3 may be filled into the hole 211, or may be filled between the conductive layer 21 and the camera module sub-board from a side, of the conductive layer 21, far away from the camera module sub-board through the hole 211 on the conductive layer 21, so that both sides of the conductive layer 21 can have the solder 3. In the soldering process, the melted solder 3 may completely wrap the soldering part on the conductive layer 21 and fix the soldering part to the camera module sub-board, to improve soldering strength between the conductive layer 21 and the camera module sub-board. In addition, in this embodiment, only the solder 3 is added to the conductive layer 21, and the solder 3 does not need to be separately added to the camera module sub-board. This simplifies the soldering operation.

In addition, in this embodiment, as shown in FIG. 7 and FIG. 8, the insulation layer 22 may completely wrap the conductive layer 21, and a window 24 is disposed only at a position opposite to the soldering region, so that the soldering region can be exposed through the window 24, and the solder 3 is added to the soldering region and the soldering operation is performed through the window 24. The soldering region may be disposed at a specified position between two ends of the conductive layer 21, that is, the soldering region has the insulation layer 22 on both sides of the flexible flat cable 2 in a length direction. Bending resistance of the flexible flat cable 2 on both sides of the soldering region may be improved through the insulation layer 22. After the soldering is completed, strength of the soldering position may still be ensured without glue dispensing. In addition, a manner of soldering the camera module sub-board and the FPC flat cable is used, so that Z-direction space between the camera module sub-board and the housing of the notebook computer may be reduced, thereby reducing an entire thickness of a screen side and implementing a thin design of the notebook computer. In addition, the manner of soldering the camera module sub-board and the FPC flat cable is used to replace application of a conventional connector, so that a width of the camera module sub-board may be reduced, and a screen-to-body ratio competitiveness of the notebook computer may be improved.

### Embodiment 2

The electronic device may be a display product, the carrier board 1 may be a microphone sub-board, and the flexible flat cable 2 is an FFC flat cable. One end of the FFC flat cable may be soldered to the microphone sub-board by using a laser soldering process, an ultrasonic soldering process, a reflow soldering process, a hot bar reflow soldering process, or the like. The other end of the FFC flat cable is connected to a mainboard of the display product, so that signal transmission between the mainboard and the microphone sub-board may be implemented through the FFC flat cable. In this embodiment, as shown in FIG. 5 and FIG. 6, the hole 211 for adding the solder 3 may be disposed on the conductive layer 21 of the FFC flat cable in a manner of mechanical drilling 211, laser drilling 211, or the like, the insulation layer 22 is disposed outside the conductive layer 21, and a material of the insulation layer 22 is a combination of PET and PI, as shown in FIG. 12. The conductive layer 21 is a tin-plated copper wire.

In this embodiment, the solder 3 may be filled into the hole 211, or may be filled between the conductive layer 21 and the microphone sub-board from a side, of the conductive layer 21, far away from the microphone sub-board through the hole 211 on the conductive layer 21, so that both sides of the conductive layer 21 can have the solder 3, and the solder 3 is a tin material. In the soldering process, the melted tin material may completely wrap the soldering part on the conductive layer 21 and fix the soldering part to the microphone sub-board, to improve soldering strength between the conductive layer 21 and the microphone sub-board. In addition, in this embodiment, only the tin material is added to the conductive layer 21, and the tin material does not need to be separately added to the microphone sub-board. This simplifies the soldering operation.

In addition, in this embodiment, the insulation layer 22 includes a PET layer 25 and a PI layer 26. After the insulation layer 22 is disposed on the conductive layer 21, the PET layer 25 and the PI layer 26 are interconnected in a length direction of the conductive layer 21, where the PI layer 26 covers a position, of the conductive layer 21, near the soldering region, so that a high-temperature-resistant feature of the PI material may be used to avoid a problem of heat melting and ensure soldering quality. However, the PET material is used at the position far away from the soldering region, so that costs of the insulation layer 22 may be effectively reduced while insulation and protection effect is implemented.

In this embodiment, the conductive layer 21 is a tin-plated copper wire. During soldering, a temperature at the soldering position is high, and a tin layer and the tin material on the copper wire are melted and combined into one, so that a reliable connection between the conductive layer 21 and the microphone sub-board is implemented by melting the tin layer and the tin material.

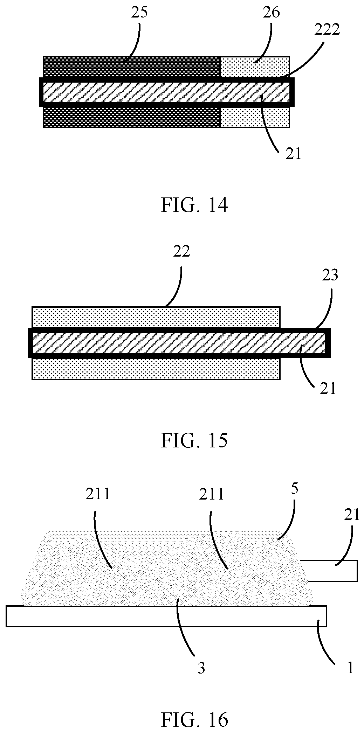

In addition, as shown in FIG. 9 and FIG. 14, the soldering region is disposed at an end of the conductive layer 21, to be specific, a segment of length located at the end of the conductive layer 21 is the soldering region, and the end, of the conductive layer 21, having the soldering region extends out from the insulation layer 22, and can be directly soldered to the microphone sub-board without disposing a window 24 on the insulation layer 22. This simplifies the process.

In this embodiment, the tin-plated copper wire is used, and the hole 211 for adding the tin material is provided on the tin-plated copper wire, so that soldering strength is effectively improved, and there is no need to perform glue dispensing processing in the soldering region. This simplifies the process. In addition, a manner of soldering the microphone sub-board and the FFC flat cable is used to replace application of a conventional connector, so that sizes such as a width of the microphone sub-board can be further reduced, thereby increasing space in a display architecture, and saving production costs.

### Embodiment 3

The electronic device may be a new sandwich architecture. The sandwich architecture includes a multilayer PCB board, the flexible flat cable 2 is an FFC flat cable, and the FFC flat cable is soldered to the multilayer PCB board, that is, the multilayer PCB board may implement signal transmission and conduction through the FFC flat cable by using the soldering process.

In this embodiment, as shown in FIG. 3, the conductive layer 21 of the FFC flat cable is the tin-plated copper wire, and no hole 211 needs to be drilled on the tin-plated copper wire. Before soldering, the solder may be first added to the soldering position of the PCB board, then the soldering region of the FFC flat cable is lapped to the top of the solder on the PCB board, and then the solder is added to a side that is of the FFC flat cable and that is away from the PCB board, so that both sides of the soldering region of the FFC flat cable are covered by the solder. During soldering, the tin layer on the tin-plated copper wire and the tin material are melted and combined into one, so that reliable soldering between the FFC flat cable and the multilayer PCB board is implemented by melting of the tin layer and the tin material. The soldering manner in this embodiment is used, so that after soldering, there is no need for glue dispensing processing, that is, strength of the soldering position can be ensured.

It should be noted that, the soldering process is used, so that the connection between the FFC flat cable and the multilayer PCB board is implemented to replace the existing connector, and flexibility of the FFC flat cable may be fully utilized to implement 180° reflexion between the multilayer PCB boards, to implement the connection between the multilayer PCB boards, and no support needs to be disposed between the multilayer PCB boards, so that a Z-direction height of the sandwich architecture is effectively reduced, and production costs are saved.

In this embodiment, as shown in FIG. 15, the material of the insulation layer 22 is PI, so that a high-temperature-resistant feature of the PI material may be used to avoid a problem of heat melting and ensure soldering quality.

In addition, as shown in FIG. 9 and FIG. 15, the soldering region is disposed at an end of the conductive layer 21, to be specific, a segment of length located at the end of the conductive layer 21 is the soldering region, and the end, of the conductive layer 21, having the soldering region extends out from the insulation layer 22, and can be directly soldered to the PCB board without disposing a window 24 on the insulation layer 22. This simplifies the process.

### Embodiment 4

The electronic device may be a flexible electronic product, such as a foldable screen, a flexible keyboard, or a flexible wearable electronic product. Various substrates are integrated in the flexible electronic product. A flexible flat cable 2 used to connect the substrates is an FFC flat cable, and the FFC flat cable is soldered to the substrate. That is, signal transmission and conduction between the substrates may be implemented through the FFC flat cable. The substrate may be an FFC board or an FPC board.

As shown in FIG. 5 and FIG. 12, the conductive layer 21 of the FFC flat cable is a copper wire, the hole 211 for adding the solder 3 may be disposed on the copper wire in a manner of mechanical drilling 211, laser drilling 211, or the like, and the solder 3 is a tin material. The tin material may be filled into the hole 211, or may be filled between the conductive layer 21 and the substrate from a side, of the conductive layer 21, far away from the substrate through the hole 211, so that both sides of the conductive layer 21 can have the tin material. In the soldering process, the melted tin material may completely wrap the soldering part on the conductive layer 21 and fix the soldering part to the substrate, to improve soldering strength between the conductive layer 21 and the substrate. In addition, in this embodiment, only the tin material is added to the conductive layer 21, and the tin material does not need to be separately added to the microphone sub-board. This simplifies the soldering operation.

In this embodiment, as shown in FIG. 12, the insulation layer 22 includes a PET layer 25 and a PI layer 26. After the insulation layer 22 is disposed on the conductive layer 21, the PET layer 25 and the PI layer 26 are interconnected in a length direction of the conductive layer 21, where the PI layer 26 covers a position, of the conductive layer 21, near the soldering region, so that a high-temperature-resistant feature of the PI material may be used to avoid a problem of heat melting and ensure soldering quality. However, the PET material is used at the position far away from the soldering region, so that costs of the insulation layer 22 may be effectively reduced while insulation and protection effect is implemented.

In addition, as shown in FIG. 9, the soldering region is disposed at an end of the conductive layer 21, to be specific, a segment of length located at the end of the conductive layer 21 is the soldering region, and the end, of the conductive layer 21, having the soldering region extends out from the insulation layer 22, and can be directly soldered to the substrate without disposing a window 24 on the insulation layer 22. This simplifies the process.

As shown in FIG. 16, the conductive layer 21 in this embodiment is soldered through a copper wire that is not tin-plated. After the soldering is completed, glue dispensing 5 processing may be performed on the soldering position, to further improve the connection strength between the FFC flat cable and the substrate at the soldering position.

It should be noted that the flexible electronic product needs to be bent in some application scenarios. Therefore, in this embodiment, the soldering process is used, that is, the connection between the FFC flat cable and the substrate is implemented, and flexibility of the FFC flat cable may be fully utilized to implement 180° reflexion, so that a matching design of the flexible electronic product in terms of a bending angle has larger design space, and the soldering connection manner replaces the application of the existing connector or the like. This significantly reduces production costs.

The foregoing descriptions are merely preferred embodiments of this application, and are not intended to limit this application. For a person skilled in the art, this application may have various modifications and variations. Any modification, equivalent replacement, improvement, or the like made without departing from the spirit and principle of this application shall fall within the protection scope of this application.

## Claims

1. An electronic device, comprising a housing and a display screen, wherein the display screen is disposed on the housing, the electronic device further comprises a carrier board and a flexible flat cable, the carrier board is loaded with a device, the carrier board and the flexible flat cable are disposed between the housing and the display screen, and the flexible flat cable is soldered to the carrier board.

2. The electronic device according to claim 1, wherein a height of soldering between the flexible flat cable and the carrier board is less than a height of the device on the carrier board, or a thickness of soldering between the flexible flat cable and the carrier board is less than a thickness of the device on the carrier board.

3. The electronic device according to claim 1, wherein the flexible flat cable comprises a conductive layer, and the conductive layer is at least partially provided with a soldering layer; and/or
a hole for filling solder is disposed on the conductive layer.

4. The electronic device according to claim 2, wherein the flexible flat cable further comprises an insulation layer, a soldering region is disposed on a conductive layer, and the insulation layer covers a part that is on the conductive layer and that is located outside the soldering region.

5. The electronic device according to claim 4, wherein a window is disposed on the insulation layer, and the window is aligned with a position of the soldering region.

6. The electronic device according to claim 4, wherein the soldering region is disposed at an end of the conductive layer, and the end that is on the conductive layer and that has the soldering region extends out from the insulation layer.

7. The electronic device according to claim 6, wherein in a soldered state, an adhesive layer is disposed between the soldering region and the insulation layer.

8. The electronic device according to claim 4, wherein a material of the insulation layer is one or a combination of two or more of polytrimethylene terephthalate (PET), polyimide (PI), liquid crystal polymer (LCP), and polyether ether ketone (PEEK).

9. The electronic device according to claim 8, wherein the insulation layer comprises a polytrimethylene terephthalate (PET) layer and a polyimide (PI) layer, the polyimide (PI) layer covers a position, of the conductive layer, near the soldering region, and the polytrimethylene terephthalate (PET) layer covers a position, of the conductive layer, far away from the soldering region.

10. The electronic device according to any one of claims 4 to 9, wherein the insulation layer comprises a first film layer and a second film layer, and the first film layer and the second film layer are respectively disposed on two sides of the conductive layer.

11. The electronic device according to any one of claims 1 to 9, wherein the flexible flat cable is an FFC flat cable or an FPC flat cable.

12. The electronic device according to any one of claims 1 to 9, wherein a material of the soldering layer is tin, gold, or silver.

13. The electronic device according to any one of claims 1 to 9, wherein the conductive layer comprises at least one copper sheet.

14. The electronic device according to any one of claims 1 to 9, wherein the flexible flat cable is soldered to the carrier board by using a laser soldering process, an ultrasonic soldering process, a reflow soldering process, or a hot bar reflow soldering process.

15. The electronic device according to any one of claims 1 to 9, wherein the carrier board is one of a camera module sub-board, a microphone sub-board, a multilayer PCB board, an FPC board, or an FFC board.
